# EUROPEAN PATENT SPECIFICATION

(11) **EP 2 308 098 B1**
(45) Date of publication and mention of the grant of the patent: **01.02.2012**
(21) Application number: 09790282.9
(22) Date of filing: 10.07.2009
(51) Int. Cl.: H01L 31/048, B32B 17/06, B32B 27/32

(54) **METHOD OF MAKING A LAMINATED GLASS/POLYOLEFIN FILM STRUCTURE**
VERFAHREN ZUR HERSTELLUNG EINER VERBUNDGLAS-/POLYOLEFINFOLIENSTRUKTUR
PROCÉDÉ DE FABRICATION D'UNE STRUCTURE LAMINÉE VERRE/FILM DE POLYOLÉFINE

(30) Priority: 15.07.2008 US 80849 P
(43) Date of publication of application: 13.04.2011
(73) Proprietor: Dow Global Technologies LLC, Midland, MI 48674 (US)
(72) Inventor: WEAVER, John, D., Pearland TX 77584 (US); WU, Shaofu, Sugar Land TX 77479 (US); HU, Yanli, Shangahi 200433 (CN)
(74) Representative: Hull, John Philip
(86) International application number: PCT/US2009/050266
(87) International publication number: WO 2010/009017

(56) References cited:
- WO-A-89/00500
- WO-A-2008/036222
- JP-A- 56 167 731
- US-A- 3 312 574
- US-A- 6 159 608

## Description

### FIELD OF THE INVENTION

This invention relates to laminated structures. In one aspect, the invention relates to laminated structures of glass and polyolefin film while in another aspect, the invention relates to photovoltaic modules. In still another aspect, the invention relates to a method of making a laminated structure in which a polyolefin film is in adhering contact with glass while in yet another aspect, the invention relates to a method making a laminated structure in which the polyolefin film is both silane-crosslinked and exhibits good adhesion to glass.

### BACKGROUND OF THE INVENTION

The most common incumbent material for an encapsulant in a photovoltaic (PV) panel is poly(ethylene-co-vinyl acetate) (EVA). Optical clarity, moldability and low cost are among its desirable qualities. During the lamination process to construct a typical PV panel, the EVA encapsulant is chemically crosslinked by the action of an organic peroxide. The primary disadvantage of EVA as an encapsulant is that it is susceptible to hydrolysis by reaction with ambient moisture, which results in the formation of acetic acid which in turn can damage the PV cell. As a consequence, PV panels made with EVA have an unacceptably short life.

Low density polyolefins, such as poly(ethylene-co-octene) satisfy many of the requirements of an encapsulant, including optical clarity, moldability and low cost (even lower than EVA), plus they are not affected by hydrolysis. However, unmodified polyolefins do not have sufficient adhesion to glass, nor do they have sufficient mechanical strength at elevated temperatures.

Polyolefins that are modified to contain trialkoxysilane functional groups exhibit acceptable adhesion to glass because during the lamination process to construct the PV panel, the alkoxysilane groups in the resin and the silanol groups that naturally occur at the surface of the glass undergo a non-catalyzed condensation reaction that form strong and hydrolytically stable siloxane linkages between the resin and the glass. However, such an encapsulant still does not have sufficient mechanical strength at elevated temperatures.

Polyolefins that contain trialkoxysilane groups will react with water in the presence of a catalyst to form silanol functional groups, and these groups further react with each other, also in the presence of a catalyst, to form siloxane crosslinks. Typically, these two reactions occur very slowly in the absence of a catalyst. Catalysts for these reactions can be either an acid or base. Lewis acids are commonly used to induce crosslinking. The crosslinked encapsulant has very good mechanical strength at elevated temperatures, but it exhibits poor adhesion to glass. This is because some of the alkoxysilane groups on the surface of the encapsulant that are required for reaction with the glass surface have been converted to siloxane groups, and siloxane groups are not reactive with the glass surface. Thus the more alkoxysilane groups on the surface of the encapsulant that have been converted to siloxane groups, the poorer the adhesion of the encapsulant to the glass surface.

For these and other reasons, the industry for laminated glass/polyolefin film laminated structures, such as PV panels, has a continuing interest in developing a method for preparing a structure in which the polyolefin-containing alkoxysilane groups is both crosslinked and exhibits good adhesion to the glass.

WO 89/000500 describes a bag and a method of making said bag are described. The bag consists of a multilayered, preferably two- or three-layered polymer material. The layers consist of polyolefin, preferably polyethylene, and of crosslinked olefin copolymer obtained by crosslinking of an olefin copolymer with hydrolysable silane groups, such as poly(ethylene/vinyl trimethoxy silane), under the action of water and silanol condensation catalyst. For producing the multilayered material, the silanol condensation catalyst is provided in a layer separate from the crosslinkable layer, for example in the polyolefin layer or in a separate layer, such as a master batch layer of silanol condensation catalyst. The multilayered material is produced by coextrusion and used for manufacturing bags in conventional manner, whereupon the crosslinkable polymer is crosslinked by subjecting the bag to the action of moisture and causing the silanol condensation catalyst to migrate into the crosslinkable layer or layers.

### BRIEF SUMMARY OF THE INVENTION

According to this invention, the polymeric film or encapsulant is a polyolefin that contains alkoxysilane groups, and during the lamination process to construct the a laminated structure of polyolefin film and glass, .e.g., a PV panel, a catalyst for promoting the crosslinking of the alkoxysilane groups is applied in a controlled fashion such that the crosslinking process can proceed within the bulk of the resin, and the process of adhering the polyolefin film to the glass can proceed at the surface of the resin. Adding the crosslinking catalyst to the extruder as the film is cast results in a homogeneous distribution of catalyst throughout the film and this, in turn, results in a film that does not have good adhesion to glass. However, by adding the catalyst away from the surface of the film that will contact the glass, both good adhesion and good mechanical strength at elevated temperature are obtained.

In one embodiment, the invention is a laminated structure comprising (i) a glass layer, (ii) a first polyolefin (PO) layer comprising a PO grafted with an alkoxysilane group, (iii) a catalyst layer, and (iv) a second polyolefin layer comprising a PO grafted with an alkoxysilane group, each layer having opposing facial surfaces and :
A. One facial surface of the first PO layer in adhering contact with one facial surface of the glass layer;
B. One facial surface of the catalyst layer in adhering contact with the facial surface of the first PO layer opposite the facial surface of the first PO layer in adhering contact with the glass layer; and
C. One facial surface of the second PO layer in adhering contact with the facial surface of the catalyst layer opposite the facial surface of the catalyst layer in adhering contact with the first PO layer.

In one embodiment, the invention is a method of making a laminated structure, the structure comprising (i) a glass layer, (ii) a first polyolefin (PO) layer comprising a PO grafted with an alkoxysilane group, (iii) a catalyst layer, and (iv) a second PO layer comprising a PO grafted with an alkoxysilane group, each layer having opposing facial surfaces, the method comprising the steps of applying in adhering contact:
A. One facial surface of the first PO layer to one facial surface of the glass layer;
B. The catalyst layer to the facial surface of the first PO layer opposite the facial surface of the first PO layer in adhering contact with the glass layer; and
C. The second PO layer to the facial surface of the catalyst layer opposite the facial surface of the catalyst layer in adhering contact with the first PO layer.
The layers can be applied to one another in any order, e.g., the second PO layer can be applied to the catalyst layer before the catalyst layer is applied to the first PO layer, or the catalyst layer can be applied to the first PO layer before the first PO layer is applied to the glass.

In one embodiment, the catalyst may be painted, sprayed, or wiped on the surface of the first PO layer that is opposite the facial surface of the PO layer that is to contact with the glass. The catalyst may be applied as a pure substance, or it may be dissolved in a solvent, dispersed in an inert carrier, or emulsified.

In one embodiment, the catalyst may be homogenously distributed within a thin film comprising a polyolefin that has not been modified with alkoxysilane functional groups. The film is applied as one layer of a multi-layer laminate structure. Thus, in the lamination process to construct, for example, a PV panel, the first PO layer is applied to the glass, and then a thin film containing the catalyst is placed in contact with the first PO layer forming a sandwich structure with the glass on one side, the film with catalyst on the other side, and the first PO layer in the center. The catalyst can diffuse from the thin film into the first PO layer to catalyze crosslinking. The film containing the catalyst is not crosslinked, and it can be prepared by adding the catalyst to a polymer melt. The film is extruded sufficiently thin such that it will not deleteriously affect the mechanical strength of the laminated structure at an elevated temperature.

In one embodiment, the invention is the laminated structure made by the method described above. The laminated structure can take the form of, among other things, a PV-panel or module, or a solar cell, or safety glass, or insulating glass or the like.

### BRIEF DESCRIPTION OF THE DRAWINGS

Figure. 1 is an illustration of a five-layer laminate structure of which the fourth layer is a catalyst layer.

Figure 2 illustrates a scheme of architecture for compression molding.

Figure 3 is a graph reporting the effect of catalyst concentration on the adhesion of a PO film layer to glass.

Figure 4 is a graph reporting comparative DMTA results of a crosslinked PO and EVA as a function of temperature.

### DETAILED DESCRIPTION OF THE PREFERRED EMBODIMENT

The numerical ranges in this disclosure are approximate, and thus may include values outside of the range unless otherwise indicated. Numerical ranges include all values from and including the lower and the upper values, in increments of one unit, provided that there is a separation of at least two units between any lower value and any higher value. As an example, if a compositional, physical or other property or process parameter, such as, for example, molecular weight, viscosity, melt index, temperature, etc., is from 100 to 1,000, it is intended that all individual values, such as 100, 101, 102, *etc*., and sub ranges, such as 100 to 144, 155 to 170, 197 to 200, etc., are expressly enumerated. For ranges containing values which are less than one or containing fractional numbers greater than one (e.g., 1.1, 1.5, *etc.*), one unit is considered to be 0.0001, 0.001, 0.01 or 0.1, as appropriate. For ranges containing single digit numbers less than ten (*e.g*., 1 to 5), one unit is typically considered to be 0.1. These are only examples of what is specifically intended, and all possible combinations of numerical values between the lowest value and the highest value enumerated, are to be considered to be expressly stated in this disclosure. Numerical ranges are provided within this disclosure for, among other things, density, melt index, amount of alkoxysilane groups in the PO resin, and relative amounts of ingredients in various formulations

The term "comprising" and its derivatives are not intended to exclude the presence of any additional component, step or procedure, whether or not the same is specifically disclosed. In order to avoid any doubt, any process or composition claimed through use of the term "comprising" may include any additional steps, equipment, additive, adjuvant, or compound whether polymeric or otherwise, unless stated to the contrary. In contrast, the term, "consisting essentially of" excludes from the scope of any succeeding recitation any other component, step or procedure, excepting those that are not essential to operability. The term "consisting of" excludes any component, step or procedure not specifically delineated or listed. The term "or", unless stated otherwise, refers to the listed members individually as well as in any combination.

"Composition" and like terms mean a mixture of two or more materials. Included in compositions are pre-reaction, reaction and post-reaction mixtures the latter of which will include reaction products and by-products as well as unreacted components of the reaction mixture and decomposition products, if any, formed from the one or more components of the pre-reaction or reaction mixture.

"Blend", "polymer blend" and like terms mean a composition of two or more polymers. Such a blend may or may not be miscible. Such a blend may or may not be phase separated. Such a blend may or may not contain one or more domain configurations, as determined from transmission electron spectroscopy, light scattering, x-ray scattering, and any other method known in the art. Blends are not laminates, but one or more layers of a laminate may contain a blend.

"Polymer" means a polymeric compound prepared by polymerizing monomers, whether of the same or a different type. The generic term polymer thus embraces the term homopolymer, usually employed to refer to polymers prepared from only one type of monomer, and the term interpolymer as defined below. It also embraces all forms of interpolymers, e.g., random, block, etc. The terms "ethylene/α-olefin polymer", "propylene/α-olefin polymer" and "silane copolymer" are indicative of interpolymers as described below.

"Interpolymer" means a polymer prepared by the polymerization of at least two different monomers. This generic term includes copolymers, usually employed to refer to polymers prepared from two different monomers, and polymers prepared from more than two different monomers, e.g., terpolymers, tetrapolymers, etc.

"Catalytic amount" and like terms means an amount of catalyst sufficient to promote the rate of reaction between two or more reactants by a discernable degree.

"Crosslinking amount" and like terms means an amount of crosslinking agent or radiation or moisture or any other crosslinking compound or energy sufficient to impart at least a detectable amount of crosslinking in the composition or blend under crosslinking conditions.

"Layer" means a single thickness, coating or stratum continuously or discontinuously spread out or covering a surface.

"Multi-layer" means at least two layers.

"Facial surface", "planar surface" and like terms mean the surfaces of the layers that are in contact with the opposite and adjacent surfaces of the adjoining layers. Facial surfaces are in distinction to edge surfaces. A rectangular layer comprises two facial surfaces and four edge surfaces. A circular layer comprises two facial surfaces and one continuous edge surface.

"In adhering contact" and like terms mean that one facial surface of one layer and one facial surface of another layer are in touching and binding contact to one another such that one layer cannot be removed for the other layer without damage to the in-contact facial surfaces of both layers.

### Polyolefin Resins

The polyolefin copolymers useful in the practice of this invention typically have, before grafting, a density of less than 0.91, preferably less than 0.905, more preferably less than 0.89, even more preferably less than 0.88 and even more preferably less than 0.875, grams per cubic centimeter (g/cm³). The polyolefin copolymers typically have a density greater than 0.85, preferably greater than 0.855 and more preferably greater than 0.86, g/cm³. Density is measured by the procedure of ASTM D-792. Low density polyolefin copolymers are generally characterized as semi-crystalline, flexible and having good optical properties, e.g., high transmission of visible and UV-light and low haze.

The polyolefin copolymers useful in the practice of this invention typically have, before grafting, a melt index greater than 0.10 and preferably greater than I gram per 10 minutes (g/10 min). The polyolefin copolymers typically have a melt index of less than 75 and preferably of less than 10, g/10 min. Melt index is measured by the procedure of ASTM D-1238 (190°C/2.16 kg).

The polyolefin copolymers useful in the practice of this invention and that are made with a single site catalyst such as a metallocene catalyst or constrained geometry catalyst, typically have, before grafting, a melting point of less than about 95, preferably less than about 90, more preferably less than about 85, even more preferably less than about 80 and still more preferably less than about 75, C. For polyolefin copolymers made with multi-site catalysts, e.g., Ziegler-Natta and Phillips catalysts, the melting point is typically 125 to 127 C. The melting point is measured by differential scanning calorimetry (DSC) as described, for example, in USP 5,783,638. Polyolefin copolymers with a low melting point often exhibit desirable flexibility and thermoplasticity properties useful in the fabrication of the modules of this invention.

The polyolefin copolymers useful in the practice of this invention include ethylene/alpha-olefin interpolymers having a α-olefin content of between about 15, preferably at least about 20 and even more preferably at least about 25, weight percent (wt%) based on the weight of the interpolymer. These interpolymers typically have an α-olefin content of less than about 50, preferably less than about 45, more preferably less than about 40 and even more preferably less than about 35, wt% based on the weight of the interpolymer. The α-olefin content is measured by ¹³C nuclear magnetic resonance (NMR) spectroscopy using the procedure described in Randall (*Rev. Macromol. Chem. Phys., C29 (2&3))*. Generally, the greater the α-olefin contents of the interpolymer, the lower the density and the more amorphous the interpolymer.

The α-olefin is preferably a C₃₋₂₀ linear, branched or cyclic α-olefin. Examples of C₃₋₂₀ α-olefins include propene, 1-butene, 4-methyl-1-pentene, 1-hexene, 1-octene, 1-decene, 1-dodecene, 1-tetradecene, 1-hexadecene, and 1-octadecene. The α-olefins can also contain a cyclic structure such as cyclohexane or cyclopentane, resulting in an α-olefin such as 3-cyclohexyl-1-propene (allyl cyclohexane) and vinyl cyclohexane. Although not α-olefins in the classical sense of the term, for purposes of this invention certain cyclic olefins, such as norbornene and related olefins, are α-olefins and can be used in place of some or all of the α-olefins described above. Similarly, styrene and its related olefins (for example, α-methylstyrene, etc.) are α-olefins for purposes of this invention. Acrylic and methacrylic acid and their respective ionomers, and acrylates and methacrylates, however, are not α-olefins for purposes of this invention. Illustrative polyolefin copolymers include ethylene/propylene, ethylene/butene, ethylene/1-hexene, ethylene/1-octene, ethylene/styrene, and the like. Ethylene/acrylic acid (EAA), ethylene/methacrylic acid (EMA), ethylene/acrylate or methacrylate, ethylene/vinyl acetate and the like are not polyolefin copolymers of this invention. Illustrative terpolymers include ethylene/propylene/1-octene, ethylene/propylene/butene, ethyleneibutene/1-octene, and ethylene/butene/styrene. The copolymers can be random or blocky.

More specific examples of olefinic interpolymers useful in this invention include very low density polyethylene (VLDPE) (e.g., FLEXOMER® ethylene/1-hexene polyethylene made by The Dow Chemical Company), homogeneously branched, linear ethylene/α-olefin copolymers (e.g. TAFMER® by Mitsui Petrochemicals Company Limited and EXACT® by Exxon Chemical Company), homogeneously branched, substantially linear ethylene/α-olefin polymers (e.g., AFFINITY® and ENGAGE® polyethylene available from The Dow Chemical Company), and olefin block copolymers such as those described in USP 7,355,089 (e.g., INFUSE® available from The Dow Chemical Company). The more preferred polyolefin copolymers are the homogeneously branched linear and substantially linear ethylene copolymers. The substantially linear ethylene copolymers are especially preferred, and are more fully described in USP 5,272,236, 5,278,272 and 5,986,028.

The polyolefin copolymers useful in the practice of this invention also include propylene, butene and other alkene-based copolymers, e.g., copolymers comprising a majority of units derived from propylene and a minority of units derived from another α-olefin (including ethylene). Exemplary propylene polymers useful in the practice of this invention include the VERSIFY® polymers available from The Dow Chemical Company, and the VISTAMAXX® polymers available from ExxonMobil Chemical Company.

Blends of any of the above olefinic interpolymers can also be used in this invention, and the polyolefin copolymers can be blended or diluted with one or more other polymers to the extent that the polymers are (i) miscible with one another, (ii) the other polymers have little, if any, impact on the desirable properties of the polyolefin copolymer, e.g., optics and low modulus, and (iii) the polyolefin copolymers of this invention constitute at least about 70, preferably at least about 75 and more preferably at least about 80, weight percent of the blend.

The PO resins used in the first and second alkoxysilane-containing PO layers of the laminated structure of this invention contain, of course, alkoxysilane groups. The alkoxysilane groups are grafted to a PO resin. Any silane that will effectively graft to and crosslink the polyolefin copolymer and lead to adhesion to glass can be used in the practice of this invention. Suitable silanes include unsaturated silanes that comprise an ethylenically unsaturated hydrocarbyl group, such as a vinyl, allyl, isopropenyl, butenyl, cyclohexenyl or γ-(meth)acryloxy allyl group, and a hydrolyzable group, such as, for example, a hydrocarbyloxy, hydrocarbonyloxy, or hydrocarbylamino group. Examples of hydrolyzable groups include methoxy, ethoxy, formyloxy, acetoxy, proprionyloxy, and alkyl or arylamino groups. Preferred silanes are the unsaturated alkoxy silanes which can be grafted onto the polymer. These silanes and their method of preparation are more fully described in USP 5,266,627. Vinyl trimethoxy silane, vinyl triethoxy silane, γ-(meth)acryloxy propyl trimethoxy silane and mixtures of these silanes are the preferred silane crosslinkers for is use in this invention.

Alternatively, silane copolymers, e.g., SILINK^{tm} poly(ethylene-co-vinyltrimethoxysilane) copolymer, can be used in combination with ethylene polymers grafted or otherwise modified with alkoxysilane groups.

The amount of silane crosslinker used in the practice of this invention, either as a group grafted to a polyolefin backbone or as unit incorporated into the polymer chain as in a silane copolymer, can vary widely depending upon the nature of the polyolefin or silane copolymer, the silane, the processing conditions, the grafting efficiency, the ultimate application, and similar factors, but typically at least 0.2, preferably at least 0.5, wt% is used based on the weight of the copolymer. Considerations of convenience and economy are usually the two principal limitations on the maximum amount of silane crosslinker used in the practice of this invention, and typically the maximum amount of silane crosslinker does not exceed 5, preferably it does not exceed 3, wt% based on the weight of the copolymer.

In those embodiments comprising two or more layers of alkoxysilane-containing PO, the amount of alkoxysilane in each layer can be the same or different, and each layer can contain the same or different alkoxysilane, e.g., in one layer the PO can be grafted with vinyl trimethoxy silane while the other layer the same or different PO is grafted with vinyl ethoxy silane, or in one layer the PO is grafted with vinyl methoxy silane while the other layer comprises poly(ethylene-co-vinyltrimethoxysilane) copolymer. In one embodiment, the amount of alkoxysilane in one layer is at least twice, thrice or four-times as much as the alkoxysilane in the other layer, or at least one of the other layers.

The silane crosslinker is grafted to the PO polymer by any conventional method, typically in the presence of a free radical initiator e.g. peroxides and azo compounds, or by ionizing radiation, etc. Organic initiators are preferred, such as any one of the peroxide initiators, for example, dicumyl peroxide, di-tert-butyl peroxide, t-butyl perbenzoate, benzoyl peroxide, cumene hydroperoxide, t-butyl peroctoate, methyl ethyl ketone peroxide, 2,5-dimethyl-2,5-di(t-butyl peroxy)hexane, lauryl peroxide, and tert-butyl peracetate. A suitable azo compound is azobisisobutyl nitrile. The amount of initiator can vary, but it is typically present in an amount of at least 0.02, preferably at least 0.03, phr. Typically, the initiator does not exceed 0.15, preferably it does not exceed about 0.10, phr. The ratio of silane crosslinker to initiator also can vary widely, but the typical crosslinker:initiator ratio is between 10:1 to 150:1, preferably between 18:1 and 100:1.

While any conventional method can be used to graft the silane crosslinker to the PO polymer, one preferred method is blending the two with the initiator in the first stage of a reactor extruder, such as a Buss kneader. The grafting conditions can vary, but the melt temperatures are typically between 160 and 260°C., preferably between 190 and 230°C., depending upon the residence time and the half life of the initiator.

The polymeric materials of this invention can comprise additives other than or in addition to cure promoters. For example, such other additives include UV-stabilizers and processing stabilizers such as trivalent phosphorus compounds. The UV-stabilizers are useful in lowering the wavelength of electromagnetic radiation (e.g., to less than 360 nm), that can be absorbed by a laminated structure, e.g., a PV module, and include hindered phenols such as Cyasorb UV2908 and hindered amines such as Cyasorb UV 3529, Hostavin N30, Univil 4050, Univin 5050, Chimassorb UV 119, Chimassorb 944 LD, Tinuvin 622 LD and the like. The phosphorus compounds include phosphonites (PEPQ) and phosphites (Weston 399, TNPP, P-168 and Doverphos 9228). The amount of UV-stabilizer is typically from about 0.1 to 0.8%, and preferably from about 0.2 to 0.5%. The amount of processing stabilizer is typically from about 0.02 to 0.5%, and preferably from about 0.05 to 0.15%.

Still other additives include, but are not limited to, antioxidants (e.g., hindered phenolics such as Irganox® 1010 made by Ciba Geigy Corp.), cling additives (e.g., polyisobutylene), anti-blocks, anti-slips, pigments and fillers (clear if transparency is important to the application). In-process additives, e.g. calcium stearate, water, etc., may also be used. These and other potential additives are used in the manner and amount as is commonly known in the art.

### Glass

Glass in the common sense refers to a hard, brittle, transparent solid, such as that used for windows, many bottles, or eyewear, including, but not limited to, soda-lime glass, borosilicate glass, acrylic glass, sugar glass, isinglass (Muscovy-glass), or aluminum oxynitride. In the technical sense, glass is an inorganic product of fusion which has been cooled to a rigid condition without crystallizing. Many glasses contain silica as their main component and glass former.

Pure silicon dioxide (SiO₂) glass (the same chemical compound as quartz, or, in its polycrystalline form, sand) does not absorb UV light and is used for applications that require transparency in this region. Large natural single crystals of quartz are pure silicon dioxide, and upon crushing are used for high quality specialty glasses. Synthetic amorphous silica, an almost 100 % pure form of quartz, is the raw material for the most expensive specialty glasses.

The glass layer of the laminated structure is typically one of, without limitation, window glass, plate glass, silicate glass, sheet glass, float glass, colored glass, specialty glass which may, for example, include ingredients to control solar heating, glass coated with sputtered metals such as silver, glass coated with antimony tin oxide and/or indium tin oxide, E-glass, SOLEX^{tm} glass (available from PPG Industries of Pittsburgh, PA) and TOROGLASS^{tm}. Alternatively, the glass layer, which may be a rigid or flexible sheet comprising a polycarbonate, an acrylic, a polyacrylate, a cyclic polyolefin such as ethylene norbornene, metallocene-catalyzed polystyrene and mixtures of two or more of these materials.

### Catalyst

Cure is promoted with a crosslinking catalyst, and any catalyst that will provide this function can be used in the practice of this invention. The catalyst used in the practice of this invention is a Lewis or Bronsted acid or base that is of sufficient strength to catalyze the crosslinking reaction at a concentration of less than I wt%, preferably less than about 5000 parts per million (ppm) and more preferably less than 2500 ppm, and as low as 100 ppm. The catalyst is resistant to decomposition under the conditions used to construct the laminated structure. Preferably, the catalyst will diffuse sufficiently rapidly through the PO resin during and after the lamination process to contact the alkoxysilane groups. Preferably, the catalyst will not interfere with or deteriorate the performance of the laminated structure, e.g., a photovoltaic cell, during the useful life of the structure. The catalyst preferably does not interfere with or deteriorate the adhesion of the PO resin to glass. Many materials can act as catalysts that are known to those familiar with the art, including, without limitation, aromatic sulfonic acids, organic tin compounds, organic titanium compounds, organic zinc compounds, and organic zirconium compounds. Specific examples include dodecylbenzenesulfonic acid, dibutyltin dilaurate and neopentyl(diallyloxy)zirconium trineodecanoate, produced commercially under the trade name Ken-React NZ01 by Kenrich Petrochemicals.

In one embodiment, the catalyst may be painted, sprayed, wiped or otherwise applied to the surface of the first PO layer that is opposite from the surface of the first PO layer that is in contact with the glass layer. The catalyst may be applied as a pure substance, or it may optionally be dissolved in a solvent, dispersed in an inert carrier, or emulsified. After the catalyst is applied to the glass layer and thus forming a catalyst layer over the first PO layer, the second PO layer is applied to the surface of the catalyst layer that is opposite the surface of the catalyst layer that is in contact with the first PO layer. The resulting laminate is a multi-layer structure comprising layers of glass, a first silane-containing PO film, catalyst, and a second silane-containing PO film. In this structure, the catalyst can diffuse throughout the film layers to catalyze crosslinking with little, if any, interference with the reaction between the silane groups of the first PO layer and those of the glass layer.

In another embodiment, the catalyst may be homogeneously distributed in a thin film made up of a polyolefin that has not been modified with alkoxysilane functional groups, and this film is applied as one layer of a multi-layer laminate structure. In a preferred variant of this embodiment, the polyolefin of the film that contains the catalyst is the same polyolefin that is modified with alkoxysilane groups that forms the first and second PO layers of the laminate structure. Thus, in the lamination process to construct the laminated structure, the polyolefin that contains alkoxysilane groups is placed in contact with the glass, and the thin film containing the catalyst is placed in contact with the silane-containing film, forming a sandwich structure with the glass on one side, the film with catalyst on the other side, and the silane-containing film in the center. The catalyst can diffuse from the thin film into the silane-containing film to catalyze crosslinking. The film containing the catalyst can be prepared by adding the catalyst to the polymer melt in an extruder. Because this particular film layer is not crosslinked, the film is prepared sufficiently thin, e.g., between 0.1 and 2, preferably between 0.2 and 2 and more preferably between 0.3 and 0.5, millimeters (mm), such that it will not deleteriously affect the mechanical strength of the structure at elevated temperatures.

The alkoxysilane-containing polyolefin copolymers after crosslinking have a gel content, as measured by ASTM D-2765, of at least 40, preferably at least 50 and more preferably at least 60 and even more preferably at least 70, percent. Typically, the gel content does not exceed 90 percent.

### Laminated Structure

The laminated structures of this invention are structures comprising (i) a glass layer, (ii) a first alkoxysilane-containing polyolefin (PO) layer, (iii) a catalyst layer, and (iv) a second alkoxysilane-containing polyolefin layer. These structures can be constructed by any one of a number of different methods. For example, in one method the structure is simply built layer upon layer, e.g., the first alkoxysilane-containing polyolefin layer is applied in any suitable manner to the glass, followed by the application of the catalyst layer to the first alkoxysilane-containing polyolefin layer, followed by the application of the second alkoxysilane-containing polyolefin layer to the catalyst layer. The application of the catalyst layer to the first alkoxysilane-containing polyolefin and the application of the second alkoxysilane-containing polyolefin to the catalyst layer can be by any process known in the art, e.g., extrusion, calendering, solution casting or injection molding. In another method, the first and second alkoxysilane-containing polyolefin layers and catalyst layer are formed into a multi-layer structure which is then applied to the glass layer.

The polymeric materials used in the practice of this invention, i.e., the first and second alkoxysilane-containing polyolefin layers, can be used to construct electronic device modules, e.g., photovoltaic or solar cells, in the same manner and using the same amounts as the encapsulant materials known in the art, e.g., such as those taught in USP 6,586,271, US Patent Application Publication US2001/0045229 A1, WO 99/05206 and WO 99/04971. These materials can be used as "skins" for the electronic device, i.e., applied to one or both face surfaces of the device, or as an encapsulant in which the device is totally enclosed within the material. Typically, the polymeric materials are applied to the device by the layer upon layer technique described above but alternatively, a multi-layer laminated structure comprising the catalyst layer sandwiched between the first and second alkoxysilane-containing polyolefin layers can first be prepared and then applied first to one face surface of the device, and then to the other face surface of the device followed by the application of a glass cover to one or both surfaces of the multi-layer laminated structures now in adherence to the electronic device.

In another embodiment, the polymeric materials used in the practice of this invention can be used to construct safety glass in the same manner as that known in the art. In this application, typically a multi-layer laminated structure comprising the catalyst layer sandwiched between the first and second alkoxysilane-containing polyolefin layers is first prepared and laminated to one sheet of glass. This is followed by laminating a second sheet of glass to the open facial surface of the multi-layer laminated structure, i.e., the polymeric film. Alternatively, the polymeric film can be built layer by layer upon one of the facial surfaces of the first glass layer.

Other applications in which the method of this invention is useful include as a sealant for insulated glass, as a coating for glass (e.g., to provide a visible or UV-light shield), and as a general adhesive for glass.

The following examples further illustrate the invention. Unless otherwise indicated, all parts and percentages are by weight.

### SPECIFIC EMBODIMENTS

### Comparative Examples 1 and 2

ENGAGE^{®} 8100 resin (available from The Dow Chemical Company) is an ethylene-octene copolymer with a density of 0.87 g/cm³ and a melt index of 1 (measured according to ASTM D1238). The resin is mixed with 100 ppm of IRGANOX 1076^{®} antioxidant (octadecyl 3,5-di-(tert)-butyl-4-hydroxyhydrocinnamate)) available from Ciba Specialties Chemicals Corporation, and several other additives identified in Table 1.

**Table 1**

| Polyolefin Formulation | | |
|---|---|---|
| **Component** | **Comparative Example 1** | **Comparative Example 2** |
| ENGAGE 8100 | 97.22 | 97.34 |
| CYASORB UV 531 | 0.3 | 0.3 |
| CHIMASSORB 944 LD | 0.1 | 0.1 |
| TINUVIN 622 LD | 0.1 | 0.1 |
| WESTON 399 | 0.2 | 0.08 |
| Silane (Dow Corning Z-6300) | 2 | 2 |
| LUPEROX-101 | 0.08 | 0.08 |
| Catalyst (DBTDL) | 0 | 0.06 |
| **Total** | 100 | 100 |

CYASORB UV 531 is a light absorber (2-hydroxy-4-*n*-octoxybenzophenone) available form Cytec Industries Inc.

CHIMASSORB 944 LD is an oligomeric hindered amine light stabilizer (poly[[6-[1,1,3,3-tetramethylbutyl)amino]-s-triazine-2,4-diyl]-[(2,2,6,6-tetramethyl-4-piperidyl)imino]-hexamethylene-[(2,2,6,6-tetramethyl-4-piperidyl)imino]]) available from Ciba Specialty Chemicals Corporation.

TINUVIN 622 LD is also a hindered amine light stabilizer (butanedioic acid, dimethylester-4-hydroxy-2,2,6,6-tetramethyl-piperidine ethanol) available from Ciba Specialty Chemicals Corporation.

WESTON 399 is a heat stabilizer (trisnonylphenyl phosphite) available from Chemtura Corporation.

DOW CORNING Z-6300 is a coupling agent (vinyltrimethoxysilane) available from the Dow Coming Corporation.

LUPEROX-101 is polymerization initiator (a mixture of 2,5-dimethyl-2,5-di(t-butylperoxy)hexane (60-100 wt%), 3,3,6,6-tetramethyl-1,2-dioxacyclohexane (3-7 wt%), and di-tert-butyl peroxide (0.1-1 wt%) available from Arkema Canada Inc.

DBTDL is dibutyltin dilaurate, an organotin used as a polymerization catalyst.

ENGAGE^{®} 8100 pellets are dried at 40°C overnight in a dryer. The pellets and the additives are then dry mixed and placed in a drum and tumbled for 30 minutes. The silane and peroxide are then poured into the drum and all are tumbled for another 15 minutes. The well mixed materials are then fed to a film extruder for film casting. Film is cast on a film line (Killion Single Screw Extruder, 24 inches sheet die). The processing conditions are summarized in Table 2.

**Table 2**

| Processing Conditions | | | | | | | | |
|---|---|---|---|---|---|---|---|---|
| | | | Temperature (°C) | | | | | |
| RPM | Amp | Head P (psi) | Zone 1 | Zone 2 | Zone 3 | Ext. Ad. | Die Ad. | Die |
| | | | | | | | | |
| 25 | 22 | 2,940 | 148.9 | 162.8 | 176.7 | 176.7 | 182 | 127/140/126 |

A 18-19 mil thickness film is saved at 5.3 ft/min. The film sample is sealed in an aluminum bag to avoid UV irradiation and absorption of moisture. The adhesion to glass and material strength at high temperature (85°C) are tested and the results are reported below.

The method used for the adhesion test is the 180° peel test. The test sample is prepared by placing the film on the top of glass under pressure in a compression molding machine. The desired adhesion width is 1.0 in. A Teflon sheet is placed between the glass and the material to separate the glass and polymer for the purpose of test setup. The conditions for the glass/film sample preparation are:
1) 160°C for 3min at 2000 lbs
2) 160°C for 30min at 8000 lbs
3) Cool to room temperature at 8000 lbs.
4) Remove the sample from the chase and allow 48 hours for the material to condition at room temperature before the adhesion test.

The adhesion strength is measured with a materials testing system (Instron 5581). The loading rate is 2 in/min and the tests are run at ambient conditions (24°C and 50% RH). A stable peel region is needed (about 2 inches) to evaluate the adhesion to glass. The ratio of peel load in the stable peel region over the film width is reported as the adhesion strength. The results are reported in Table 3.

**Table 3**

| Test Results of Adhesion to Glass | | |
|---|---|---|
| | Conditions for molding on glass | Adhesion Strength (N/mm) |
| Comp. Example 1 | 160°C, one hour | 10 |
| Comp. Example 2 | 160°C, one hour | 0.1 |

The material strength (tensile) at high temperature is tested according to ASTM D638 using a dog bone sample at 85C. The loading rate is 2 in/min. The Comparative Example 1 could not be tested at 85C because the film is too soft at this temperature to be gripped. The tensile strength (maximum stress) of the Comparative Example 2 at 85C is 0.3 MPa. Comparative Example 1 shows that film extruded without catalyst adheres to glass but does not have sufficient tensile strength. Comparative Example 2 shows that film extruded with catalyst has sufficient tensile strength, but it does not adhere to glass.

### Example of the Invention

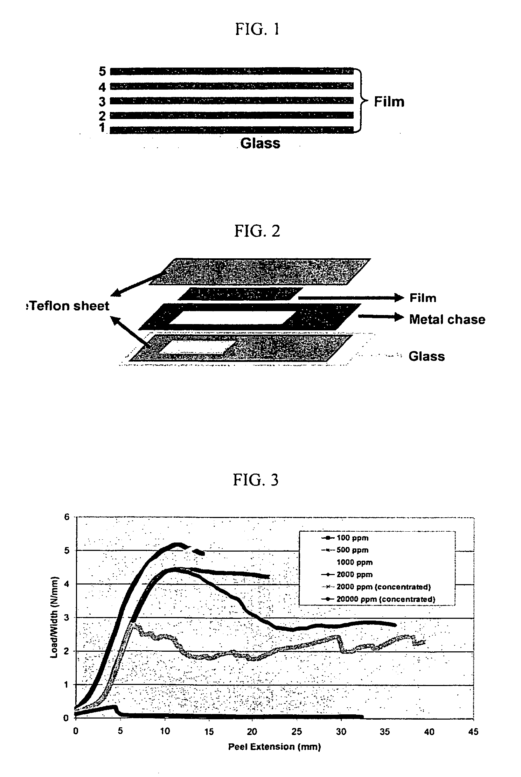

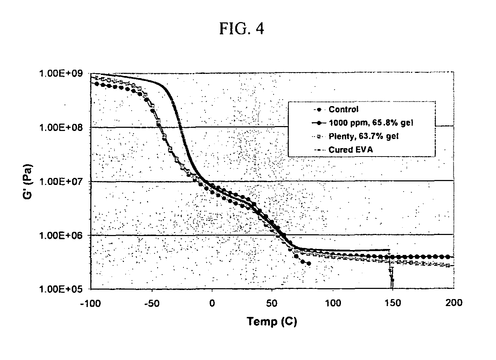

ENGAGE® 8200 resin (available from The Dow Chemical Company) is an ethylene-octene copolymer with a density of 0.87 g/cm³ and a melt index of 5 (measured according to ASTM D1238). It is grafted with VTMS and cast to film in a Killion Single Screw Extruder under conditions similar to those described above. Five layers of the VTMS-grafted polyolefin film, which weighs a total of 8 grams, are placed on a sheet of glass as shown in Figure 1. Varying amounts of catalyst (Ken-React NZ01 which is neopentyl(diallyloxy)zirconium trineodecanoate produced commercially by Kenrich Petrochemicals) are applied between layers 4 and 5 using a syringe as shown in Figure 4. The highest level of catalyst, 20,000 ppm, is applied neat, and the lower concentrations of catalyst are applied as 0.5 mL solutions dissolved in ethyl acetate.

**Table 4**

| Amounts of Catalyst Added to Multi-Layer Structure | | | | | |
|---|---|---|---|---|---|
| Sample Number | 1 | 2 | 3 | 4 | 5 |
| Amount of Catalyst Used (mg) | 160 | 16 | 8 | 4 | 0.8 |
| Catalyst Concentration in Finished Structure (ppm) | 20,000 | 2,000 | 1,000 | 500 | 100 |

| | | | | | |
|---|---|---|---|---|---|
| *Catalyst concentration was calculated by dividing the mass of the catalyst by the mass of the polymer film. | | | | | |

Adhering film to glass is achieved through compression molding by using a heated Carver press. A Teflon sheet carved in the middle and a metal chase are placed on top of the cleaned glass followed by the five layers of film, including the catalyst between layers 4 and 5. The scheme of the architecture is shown in Figure 2. The compression molding procedure is as follows:
1. 150°C for 3 minutes at 3,000 Ib;
2. 150°C for 7 minutes at 8,000 Ib; and
3. Cool to room temperature at ambient conditions.

Adhesion testing is run by using an Instron machine with the loading rate of 2 in/min at ambient conditions (24°C and 50% RH). The ratio of peel load over the film width (N/mm) is reported as the adhesion strength and the test is stopped after a stable peel region is observed. The test results are shown in Figure 3. The adhesion to glass is lost with the concentrated catalyst at 20,000 ppm, but improved when the catalyst concentration decreased to 2000 ppm. It is further improved when the diluted catalyst concentration is below 1000 ppm.

Dynamic Mechanical Testing Analysis (DMTA) is run by using an ARES with the frequency of 10 rad/sec and strain of 0.1% to measure the visco-elastic properties of samples in the solid state as a function of temperature from -100°C to 200°C. The sample without catalyst is added as the control and two samples with different catalyst concentration are tested as a comparison. Cured ethylene vinyl acetate (EVA) is tested as a benchmark. The results are shown in Figure 4.

The storage modulus of the control sample drops above 70°C and the measurement cannot be performed due to the thermal deformation of the sample. The benchmark EVA, cured at 160°C for 30 minutes to a gel content of 89.7% as measured by ASTM D2765, exhibited a storage modulus plateau at temperatures above 70°C. The two VTMS-g-EG8200 samples with catalyst show a behavior similar to that of the cured EVA. The crosslinking of these two samples is carried out in water at 65°C overnight and 90°C for one day. Their gel contents are comparable - 65.8% for the 1000 ppm sample and 63.7% for the other sample. Combined with the results of the adhesion test, 1000 ppm of catalyst are preferred for the silane crosslinked EG8200 to achieve both thermal and mechanical properties and adhesion to glass.

Although the invention has been described in considerable detail through the preceding description, drawings and examples, this detail is for the purpose of illustration. One skilled in the art can make many variations and modifications without departing from the spirit and scope of the invention as described in the appended claims.

## Claims

1. A method of making a laminated structure, the structure comprising (i) a glass layer, (ii) a first polyolefin (PO) layer comprising a PO grafted with an alkoxysilane group, (iii) a catalyst layer, and (iv) a second PO layer comprising a PO grafted with an alkoxysilane group, each layer having opposing facial surfaces, the method comprising the steps of applying in adhering contact:
A. One facial surface of the first PO layer to one facial surface of the glass layer;
B. The catalyst layer to the facial surface of the first PO layer opposite the facial surface of the first PO layer in adhering contact with the glass layer; and
C. The second PO layer to the facial surface of the catalyst layer opposite the facial surface of the catalyst layer in adhering contact with the first PO layer.

2. The method of Claim 1 in which the catalyst layer is applied by painting, spraying or wiping a composition comprising the catalyst onto one facial surface of the first PO layer.

3. The method of Claim 1 in which the catalyst layer is a film comprising a catalyst homogeneously distributed within the film.

4. The method of Claim 3 in which the film of the catalyst layer comprises the same polyolefin as that in the first and second PO layers except without the alkoxysilane groups.

5. The method of Claim 3 in which the grafted polyolefin in at least one of the first and second PO layers is a substantially linear ethylene copolymer.

6. A laminated structure comprising (i) a glass layer, (ii) a first polyolefin (PO) layer comprising a PO grafted with an alkoxysilane group, (iii) a catalyst layer, and (iv) a second polyolefin layer comprising a PO grafted with an alkoxysilane group, each layer having opposing facial surfaces and :
A. One facial surface of the first PO layer in adhering contact with one facial surface of the glass layer;
B. One facial surface of the catalyst layer in adhering contact with the facial surface of the first PO layer opposite the facial surface of the first PO layer in adhering contact with the glass layer; and
C. One facial surface of the second PO layer in adhering contact with the facial surface of the catalyst layer opposite the facial surface of the catalyst layer in adhering contact with the first PO layer.

7. The laminated structure of Claim 6 in which the first and second PO layers comprise an ethylene/α-olefin copolymer that has before grafting a density less than 0.91 g/cm³ and a melt index less than 75 g/10min.

8. The laminated structures of Claim 6 in which the catalyst layer also comprises an ethylene/α-olefin copolymer that has before grafting a density less than 0.91 g/cm³ and a melt index less than 75 g/10min.

9. The laminated structure of Claim 6 in which the catalyst layer comprises a Lewis or Bronsted acid or base.

10. The laminated structure of Claim 6 in the form of a PV panel, solar cell, safety glass or insulated glass.

## Patentansprüche

1. Verfahren zur Herstellung einer laminierten Struktur, wobei die Struktur (i) eine Glasschicht, (ii) eine erste Polyolefin(PO)-Schicht, die ein PO, das mit einer Alkoxysilangruppe gepfropft ist, enthält, (iii) eine Katalysatorschicht und (iv) eine zweite PO-Schicht, die ein PO, das mit einer Alkoxysilangruppe gepfropft ist, enthält, aufweist, wobei jede Schicht gegenüberliegende Fazialflächen aufweist und das Verfahren die Schritte des Aufbringens in haftendem Kontakt von:
A. einer ersten Fazialfläche der ersten PO-Schicht auf einer Fazialfläche der Glasschicht;
B. der Katalysatorschicht auf die Fazialfläche der ersten PO-Schicht, die der Fazialfläche der ersten PO-Schicht, die sich in haftendem Kontakt mit der Glasschicht befindet, gegenüberliegt, und
C. der zweiten PO-Schicht auf die Fazialfläche der Katalysatorschicht, die der Fazialfläche der Katalysatorschicht, die sich in haftendem Kontakt mit der ersten PO-Schicht befindet, gegenüberliegt, umfasst.

2. Verfahren nach Anspruch 1, in welchem die Katalysatorschicht durch Streichen, Sprühen oder Aufwischen einer Zusammensetzung, die den Katalysator enthält, auf eine Fazialfläche der ersten PO-Schicht aufgebracht wird.

3. Verfahren nach Anspruch 1, in welchem die Katalysatorschicht ein Film ist, der einen Katalysator enthält, der innerhalb des Films gleichmäßig verteilt ist.

4. Verfahren nach Anspruch 3, in welchem der Film der Katalysatorschicht das gleich Polyolefin wie in der ersten und zweiten PO-Schicht, aber ohne die Alkoxysilangruppen, enthält.

5. Verfahren nach Anspruch 3, in welchem das gepfropfte Polyolefin in mindestens einer der ersten und zweiten PO-Schicht ein im Wesentlichen lineares Ethylencopolymer ist.

6. Laminierte Struktur umfassend (i) eine Glasschicht, (ii) eine erste Polyolefin(PO)-Schicht, die ein PO, das mit einer Alkoxysilangruppe gepfropft ist, enthält, (iii) eine Katalysatorschicht und (iv) eine zweite Polyolefinschicht, die ein PO, das mit einer Alkoxysilangruppe gepfropft ist, enthält, wobei jede Schicht gegenüberliegende Fazialflächen und:
A. eine Fazialfläche der ersten PO-Schicht in haftendem Kontakt mit einer Fazialfläche der Glasschicht;
B. eine Fazialfläche der Katalysatorschicht in haftendem Kontakt mit der Fazialfläche der ersten PO-Schicht, die der Fazialoberfläche der ersten PO-Schicht in haftendem Kontakt mit der Glasschicht gegenüberliegt, und
C. eine Fazialfläche der zweiten PO-Schicht in haftendem Kontakt mit der Fazialfläche der Katalysatorschicht, die der Fazialfläche der Katalysatorschicht in haftendem Kontakt mit der ersten PO-Schicht gegenüberliegt,
aufweist.

7. Laminierte Struktur nach Anspruch 6, in welcher die erste und zweite PO-Schicht ein Ethylen/α-Olefin-Copolymer enthalten, das vor Pfropfen eine Dichte von weniger als 0,91 g/cm³ und einen Schmelzindex von weniger als 75 g/10 min aufweist.

8. Laminierte Struktur nach Anspruch 6, in welcher die Katalysatorschicht auch ein Ethylen/α-Olefin-Copolymer enthält, das vor Pfropfen eine Dichte von weniger als 0,91 g/cm³ und einen Schmelzindex von weniger als 75 g/10 min aufweist.

9. Laminierte Struktur nach Anspruch 6, in welcher die Katalysatorschicht eine Lewis- oder Brønsted-Säure oder -Base enthält.

10. Laminierte Struktur nach Anspruch 6 in Form eines Fotovoltaik-Panels, einer Solarzelle, eines Sicherheitsglases oder eines Isolierglases.

## Revendications

1. Procédé de fabrication d'une structure laminée, la structure comprenant (i) une couche de verre, (ii) une première couche de polyoléfine (PO) comprenant une PO greffée avec un groupe alcoxysilane, (iii) une couche catalytique, et (iv) une seconde couche de PO comprenant une PO greffée avec un groupe alcoxysilane, chaque couche comportant des surfaces faciales opposées, le procédé comprenant les étapes consistant à appliquer dans un contact par adhérence :
A. une surface faciale de la première couche de PO sur une surface faciale de la couche de verre ;
B. la couche catalytique sur la surface faciale de la première couche de PO opposée à la surface faciale de la première couche de PO en contact par adhérence avec la couche de verre ; et
C. la seconde couche de PO sur la surface faciale de la couche catalytique opposée à la surface faciale de la couche catalytique en contact par adhérence avec la première couche de PO.

2. Procédé selon la revendication 1 dans lequel la couche catalytique est appliquée en peignant, en pulvérisant ou en étalant une composition comprenant le catalyseur sur une surface faciale de la première couche de PO.

3. Procédé selon la revendication 1 dans lequel la couche catalytique est un film comprenant un catalyseur distribué de manière homogène dans le film.

4. Procédé selon la revendication 3 dans lequel le film de la couche catalytique comprend la même polyoléfine que celle de la première et de la seconde couche de PO mais sans les groupes alcoxysilane.

5. Procédé selon la revendication 3 dans lequel la polyoléfine greffée dans au moins une de la première et de la seconde couche de PO est un copolymère d'éthylène sensiblement linéaire.

6. Structure laminée comprenant (i) une couche de verre, (ii) une première couche de polyoléfine (PO) comprenant une PO greffée avec un groupe alcoxysilane, (iii) une couche catalytique, et (iv) une seconde couche de polyoléfine comprenant une PO greffée avec un groupe alcoxysilane, chaque couche comportant des surfaces faciales opposées et :
A. une surface faciale de la première couche de PO en contact par adhérence avec une surface faciale de la couche de verre ;
B. une surface faciale de la couche catalytique en contact par adhérence avec la surface faciale de la première couche de PO opposée à la surface faciale de la première couche de PO en contact par adhérence avec la couche de verre ; et
C. une surface faciale de la seconde couche de PO en contact par adhérence avec la surface faciale de la couche catalytique opposée à la surface faciale de la couche catalytique en contact par adhérence avec la première couche de PO.

7. Structure laminée selon la revendication 6 dans laquelle la première et la seconde couche de PO comprennent un copolymère éthylène/α-oléfine qui présente avant le greffage une densité inférieure à 0,91 g/cm³ et un indice de fusion inférieur à 75 g/ 10 min.

8. Structure laminée selon la revendication 6 dans laquelle la couche catalytique comprend également un copolymère éthylène/α-oléfine qui présente avant le greffage une densité inférieure à 0,91 g/cm³ et un indice de fusion inférieur à 75 g/ 10 min.

9. Structure laminée selon la revendication 6 dans laquelle la couche catalytique comprend un acide ou une base de Lewis ou de Bronsted.

10. Structure laminée selon la revendication 6 sous la forme d'un panneau PV, d'une cellule solaire, d'un verre de sécurité ou d'un verre isolé.
